# EUROPEAN PATENT APPLICATION

(11) **EP 4 572 079 A1**
(43) Date of publication of application: **18.06.2025**
(21) Application number: 24185735.8
(22) Date of filing: 01.07.2024
(51) Int. Cl.: H02J 7/00, H01M 50/296

(54) **APPARATUS FOR CHARGING OR DISCHARGING BATTERY CELL**

(30) Priority: 14.12.2023 KR 20230182104
(71) Applicant: Samsung SDI Co., Ltd., Yongin-si, Gyeonggi-do 17084 (KR)
(72) Inventor: Kim, Jeong Ho, 16678 Suwon-si, Gyeonggi-do (KR); Yeom, Gil Choun, 16678 Suwon-si, Gyeonggi-do (KR); Ji, Se Jin, 16678 Suwon-si, Gyeonggi-do (KR); Park, Myung Hyun, 16678 Suwon-si, Gyeonggi-do (KR)
(74) Representative: Gulde & Partner

(57) **Abstract**

An apparatus (100) for charging or discharging a battery cell (10) includes a charging/discharging probe (110) comprising a first contact portion (111) configured to come into detachable contact with a first surface (21) of a cell terminal (20) protruding from a battery cell (10), and a second contact portion (130) which is connected to the first contact portion (111), configured to come into contact with a second surface (22, 24) of the cell terminal (20) when the first contact portion (111) comes into contact with the first surface (21) of the cell terminal (20) and to be spaced apart from the second surface (22, 24) of the cell terminal (20) when the first contact portion (111) is spaced apart from the first surface (21) of the cell terminal (20); and a charging/discharging body (101) electrically connectable to the battery cell (10) through the charging/discharging probe (110) such that the battery cell is charged or discharged.

## Description

### BACKGROUND

### 1. Field of the Invention

Aspects of embodiments of the present disclosure relate to an apparatus for charging or discharging a battery cell.

### 2. Discussion of Related Art

In general, as the demand for portable electronic products, such as notebook computers, video cameras, and portable phones, is rapidly increasing, and the commercialization of robots, electric vehicles, and the like begins in earnest, research on high-performance repeatedly chargeable and dischargeable secondary batteries is being actively conducted.

Battery cells for secondary batteries may be manufactured by putting an electrode assembly and an electrolyte into a case and sealing the case. Battery cells manufactured in this way may be shipped after being activated through a formation process of experimentally charging or discharging the battery cells.

When battery cells are charged or discharged in a formation process or to test the charging and discharging performance of the battery cells, an apparatus for charging or discharging a battery cell, which includes a probe that comes into electrical contact with a cell terminal of the battery cell, may be used. When battery cells with high electric capacity are charged or discharged at a high speed, an amount of a current flowing through a probe and a cell terminal of the battery cell in contact therewith may increase. As a result, the cell terminal and the probe may generate heat at a high temperature, which may degrade the performance of an apparatus for charging or discharging a battery cell or may cause damage. In addition, in severe cases, a fire accident may occur.

The aforementioned information disclosed in this background section is provided for enhancement of understanding of the background technology of the present disclosure, and therefore may contain information that does not constitute the related art.

### SUMMARY

According to an aspect of embodiments of the present disclosure, an apparatus for charging or discharging a battery cell, which includes a charging/discharging probe that also comes into electrical contact with a second surface of a cell terminal, is provided.

The above and other aspects and features of the present disclosure will be described in or will be apparent from the following description of some embodiments of the present disclosure.

According to one or more embodiments of the present disclosure, an apparatus for charging or discharging a battery cell includes a charging/discharging probe comprising a first contact portion configured to come into detachable contact with a first surface of a cell terminal protruding from a battery cell, and a second contact portion which is connected to the first contact portion, configured to come into contact with a second surface of the cell terminal when the first contact portion comes into contact with the first surface of the cell terminal and be spaced apart from the second surface of the cell terminal when the first contact portion is spaced apart from the first surface of the cell terminal; and a charging/discharging body electrically connectable to the battery cell through the charging/discharging probe such that the battery cell is charged or discharged.

The charging/discharging probe may further include a hinge portion configured to support the second contact portion such that the second contact portion rotates with respect to the first contact portion.

The first contact portion, the hinge portion, and the second contact portion may be electrically connected to each other.

The hinge portion may include a hinge bracket of which a first side is fixed to the first contact portion, and a hinge pin which passes through the second contact portion and is supported on a second side of the hinge bracket.

The second contact portion may include a first end portion protruding in a first direction to protrude toward the battery cell from the hinge pin and come into contact with the second surface of the cell terminal, and a second end portion protruding in a second direction opposite the first direction from the hinge pin, and the second contact portion may rotate such that, when the first contact portion is spaced from the first surface of the cell terminal, the first end portion moves away from a central axis of the first contact portion, and the second contact portion approaches the central axis of the first contact portion.

The charging/discharging probe may further include a support frame which supports the first contact portion and is movable to approach the battery cell when the first contact portion comes into contact with the first surface of the cell terminal, and a rotation trigger which is movable together with the support frame to press the second contact portion such that the second contact portion rotates in a direction in which the second end portion moves away from the central axis of the first contact portion and the first end portion comes into close contact with the second surface of the cell terminal.

At least one of the rotation trigger and the second end portion may include an inclined surface in contact with the other of the rotation trigger and the second end portion.

The charging/discharging probe may further include a stopper configured to limit rotation of the second contact portion such that the second end portion is not proximate (e.g., excessively close) to the central axis of the first contact portion.

The charging/discharging probe may further include a second contact portion pressing spring between the first end portion and the first contact portion and configured to elastically press the second contact portion such that the first end portion moves away from the first contact portion and the second end portion approaches the first contact portion.

The second contact portion may include a first end portion protruding in the first direction to protrude toward the battery cell from the hinge pin to come into contact with the second surface of the cell terminal, and a second end portion protruding in the second direction from the hinge pin, and the second contact portion may be elastically biased in a direction in which the first end portion approaches the first contact portion and the second end portion moves away from the first contact portion.

When the first contact portion moves toward the cell terminal and an end of the first end portion comes into contact with an edge between the first surface of the cell terminal and the second surface of the cell terminal, the second contact portion may be rotatable such that the first end portion is spaced apart from a central axis of the first contact portion and the second end portion approaches the central axis of the first contact portion.

When the end of the first end portion comes into contact with the edge, an inclined surface sliding against the edge may be formed.

The charging/discharging probe may further include a stopper configured to limit rotation of the second contact portion such that the first end portion is not proximate (e.g., excessively close) to a central axis of the first contact portion.

The charging/discharging probe may further include a second contact portion pressing spring between the second end portion and the first contact portion and configured to elastically press the second contact portion such that the second end portion moves away from the first contact portion.

The second contact portion may include a leaf spring including a contact piece fixing portion fixed to the first contact portion, and a terminal contact portion extending from the contact piece fixing portion to come into contact with the second surface of the cell terminal, and when the terminal contact portion comes into contact with the second surface of the cell terminal, the terminal contact portion may come into elastic contact with the second surface of the cell terminal.

The leaf spring may further include a guide portion which, when the first contact portion moves toward the cell terminal, comes into contact with the cell terminal prior to the terminal contact portion and extends from the terminal contact portion to be bent with respect to the terminal contact portion.

When the guide portion comes into contact with an edge between the first surface of the cell terminal and the second surface of the cell terminal, the guide portion may slide against the edge, and the terminal contact portion may come into contact with the second surface of the cell terminal.

The first contact portion and the second contact portion may be electrically connected.

The second contact portion may include a plurality of second contact portions, and at least one pair of second contact portions among the plurality of second contact portions may be arranged symmetrically with the first contact portion therebetween.

The charging/discharging probe may further include a support frame which supports the first contact portion and is movable toward the battery cell such that the first contact portion comes into close contact with the first surface of the cell terminal, and a first contact portion pressing spring between the support frame and the first contact portion and configured to elastically press the first contact portion toward the cell terminal when the first contact portion comes into contact with the first surface of the cell terminal.

According to an aspect of the present disclosure, a charging/discharging probe comes into contact with not only a first surface of a cell terminal but also a second surface of the cell terminal, and a battery cell can therefore be charged or discharged at high speed.

According to another aspect of the present disclosure, heat generation may be minimized or reduced at a portion at which a cell terminal and a charging/discharging probe come into contact with each other, and performance degradation, damage, or fire accidents in a battery cell or an apparatus for charging or discharging a battery cell can therefore be prevented or substantially prevented.

However, aspects and effects obtainable through the present disclosure are not limited to the above aspects and effects, and other technical aspects and effects that are not mentioned will be clearly understood by those skilled in the art from the following description of the present disclosure.

### BRIEF DESCRIPTION OF THE DRAWINGS

The drawings attached to this specification illustrate some embodiments of the present disclosure, and further describe aspects and features of the present disclosure together with the detailed description of the present disclosure. However, the present disclosure should not be construed as being limited to the drawings.

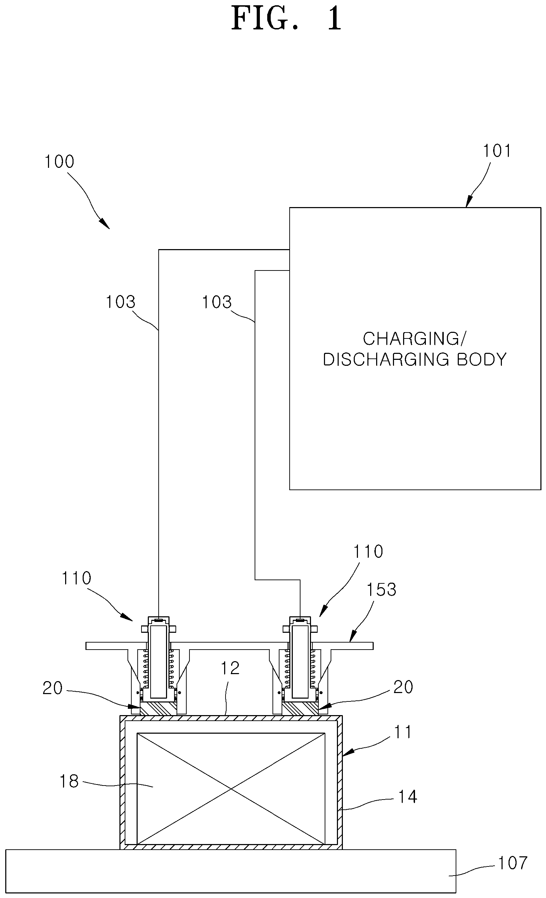

FIG. 1 is a schematic block diagram illustrating an apparatus for charging or discharging a battery cell according to an embodiment of the present disclosure;

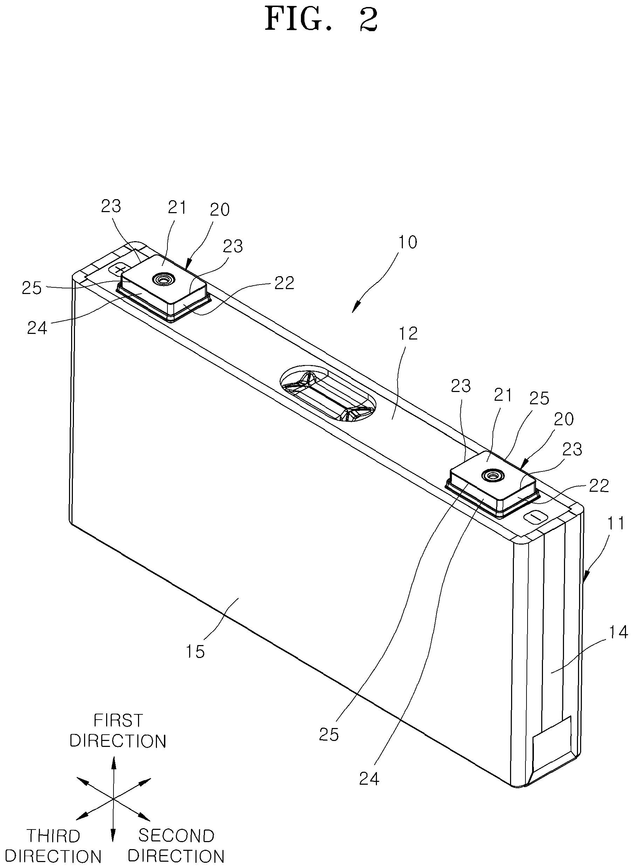

FIG. 2 is a perspective view illustrating an example of a battery cell to which the apparatus for charging or discharging a battery cell of FIG. 1 may be applied;

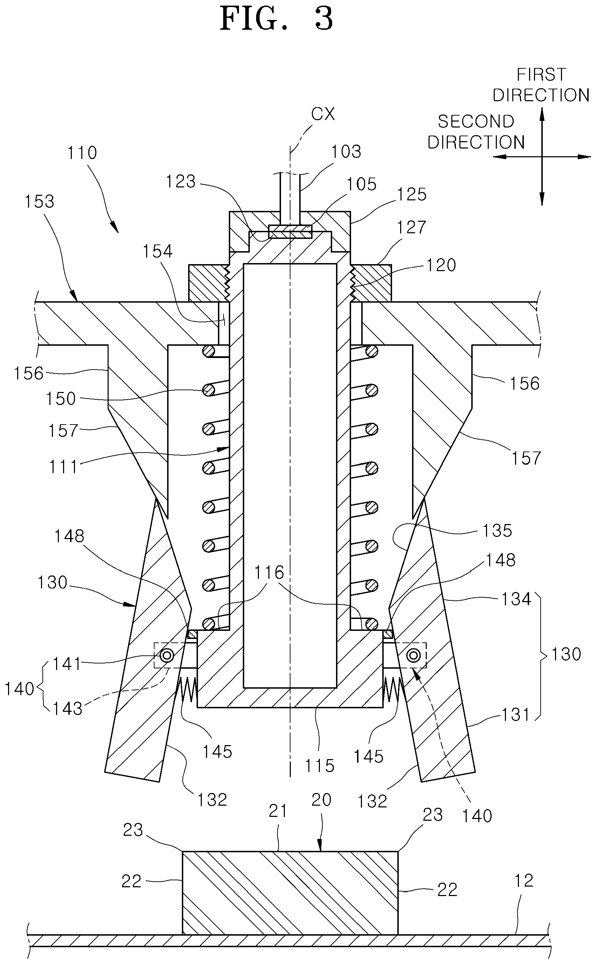

FIG. 3 is a longitudinal cross-sectional view illustrating a charging/discharging probe included in an apparatus for charging or discharging a battery cell according to an embodiment of the present disclosure, which is a view illustrating a state in which the charging/discharging probe is spaced apart from a cell terminal of a battery cell;

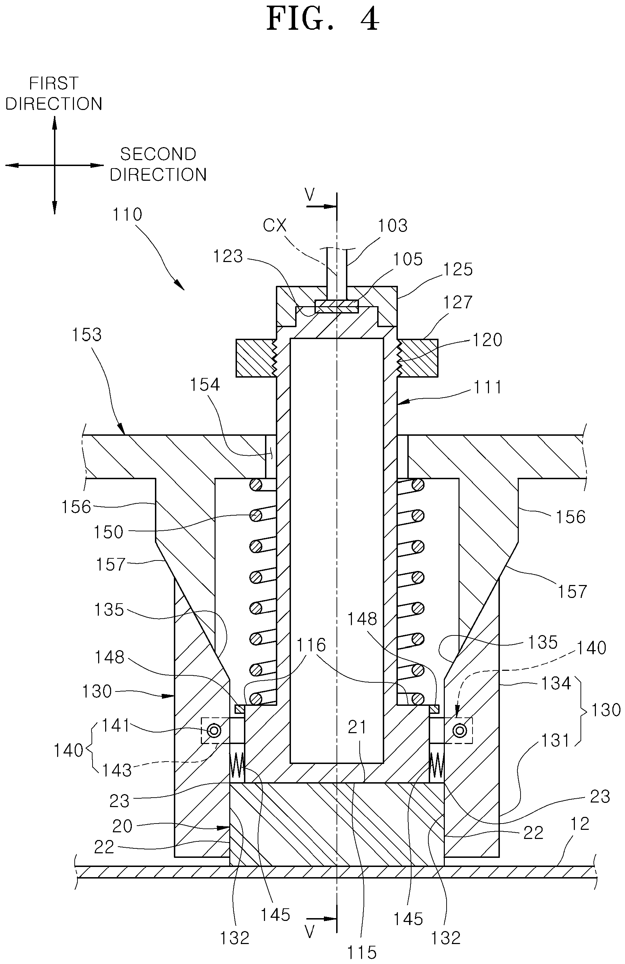

FIG. 4 is a longitudinal cross-sectional view illustrating the charging/discharging probe included in the apparatus for charging or discharging a battery cell of FIG. 3, which is a view illustrating a state in which the charging/discharging probe is in contact with the cell terminal of the battery cell;

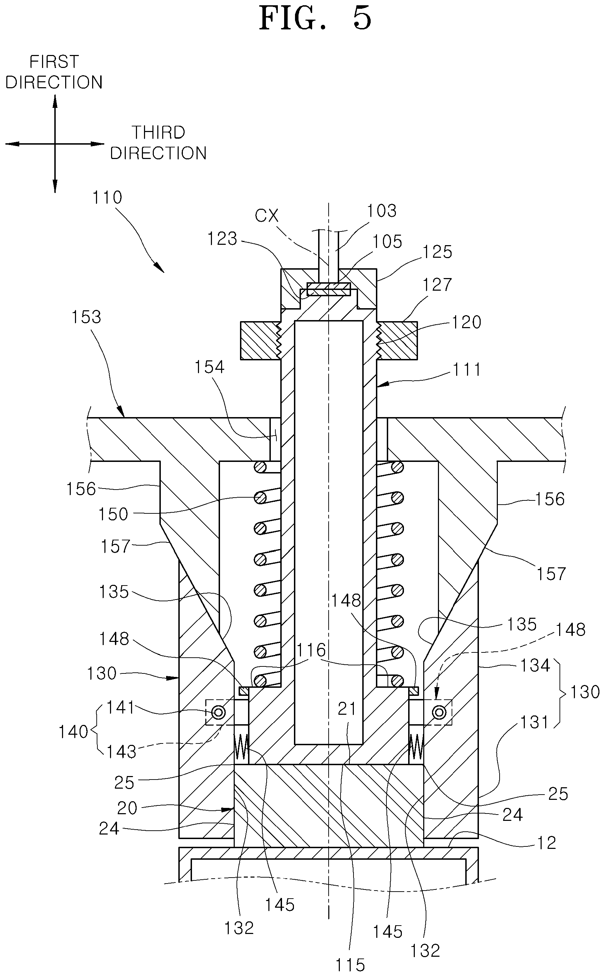

FIG. 5 is a cross-sectional view along the line V-V of FIG. 4;

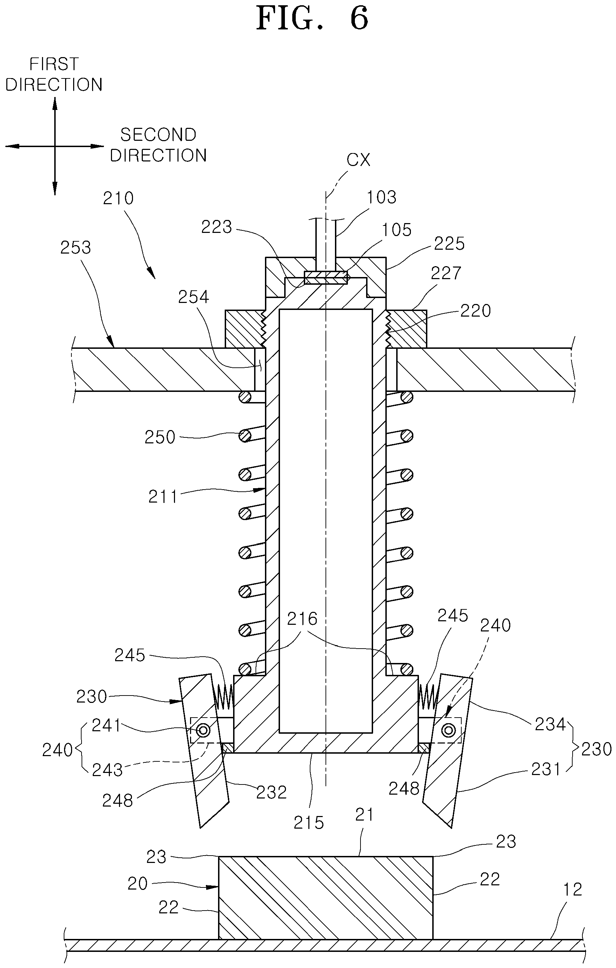

FIG. 6 is a longitudinal cross-sectional view illustrating a charging/discharging probe included in an apparatus for charging or discharging a battery cell according to another embodiment of the present disclosure, which is a view illustrating a state in which the charging/discharging probe is spaced apart from a cell terminal of a battery cell;

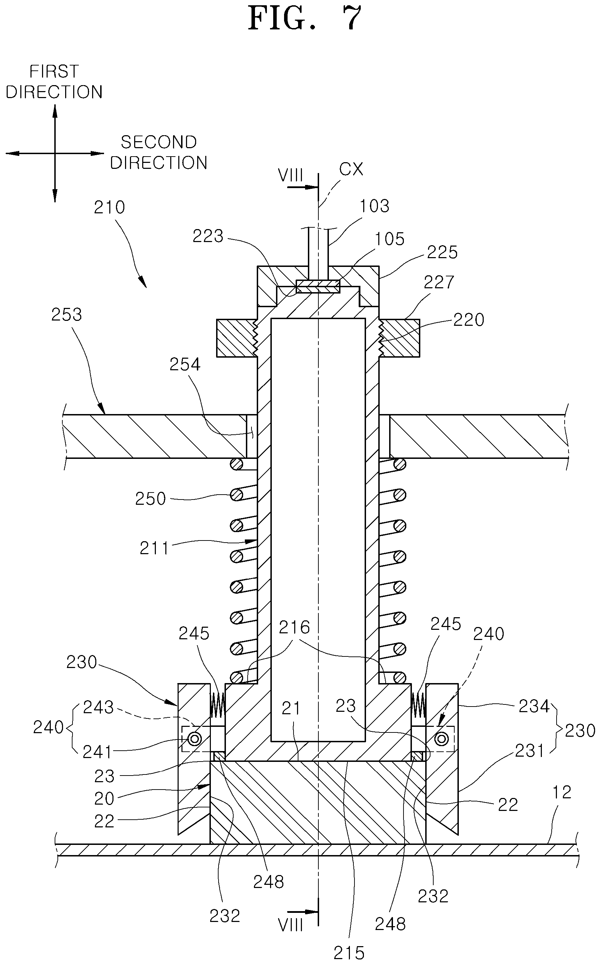

FIG. 7 is a longitudinal cross-sectional view illustrating the charging/discharging probe included in the apparatus for charging or discharging a battery cell of FIG. 6, which is a view illustrating a state in which the charging/discharging probe is in contact with the cell terminal of the battery cell;

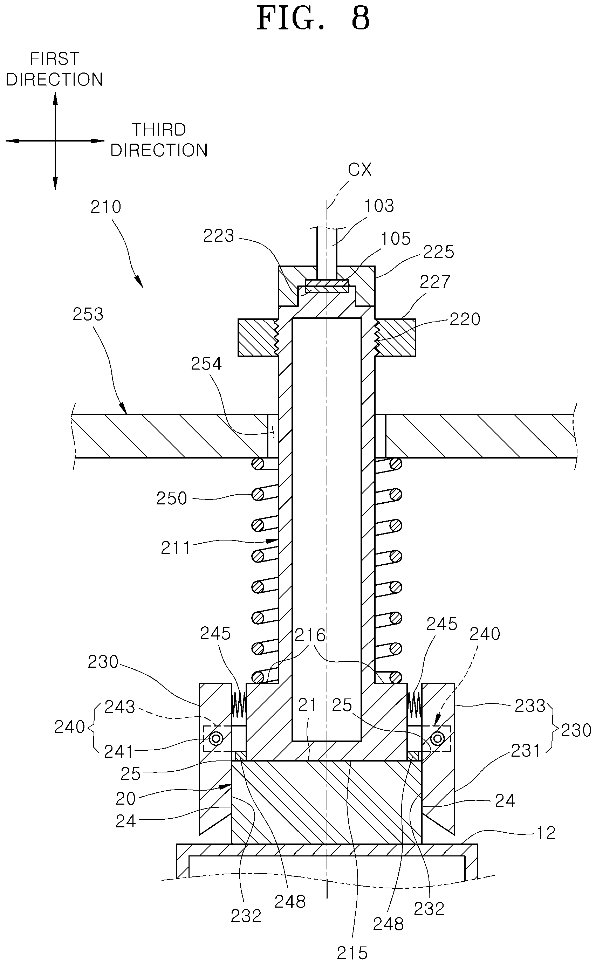

FIG. 8 is a cross-sectional view along the line VIII-VIII of FIG. 7;

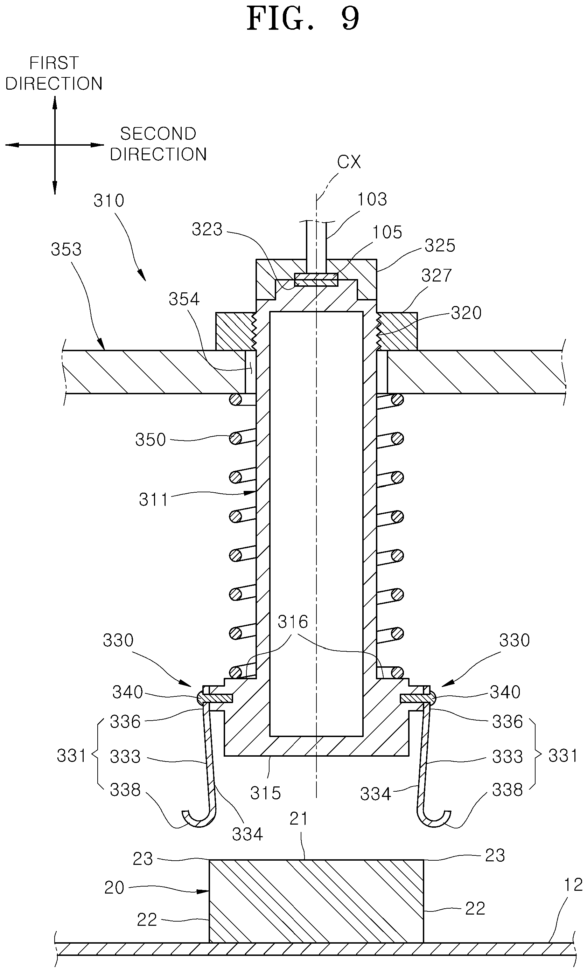

FIG. 9 is a longitudinal cross-sectional view illustrating a charging/discharging probe included in an apparatus for charging or discharging a battery cell according to another embodiment of the present disclosure, which is a view illustrating a state in which the charging/discharging probe is spaced apart from a cell terminal of a battery cell;

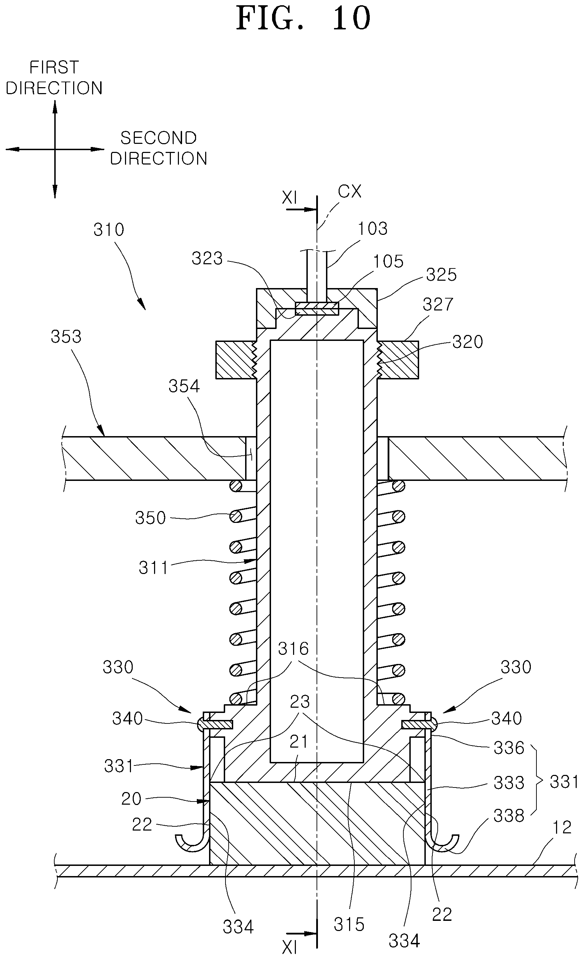

FIG. 10 is a longitudinal cross-sectional view illustrating the charging/discharging probe included in the apparatus for charging or discharging a battery cell of FIG. 9, which is a view illustrating a state in which the charging/discharging probe is in contact with the cell terminal of the battery cell; and

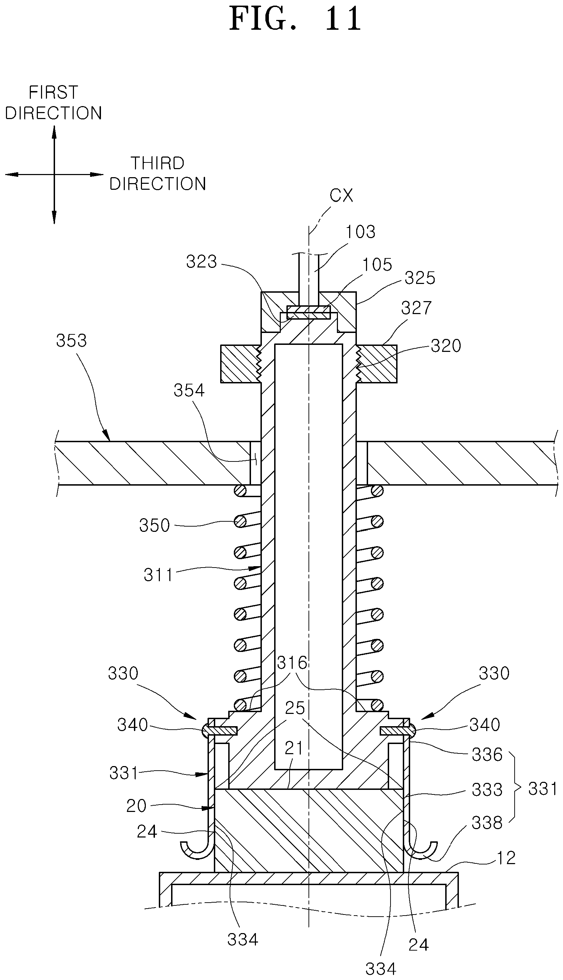

FIG. 11 is a cross-sectional view along the line XI-XI of FIG. 10.

### DETAILED DESCRIPTION

Herein, some embodiments of the present disclosure will be described, in further detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not necessarily represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same or like elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all sub-ranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are the same or substantially the same. Thus, the phrase "the same" or "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being arranged (or located or positioned) on the "above (or below)" or "on (or under)" a component, it may mean that the arbitrary element is placed in contact with the upper (or lower) surface of the component and may also mean that another component may be interposed between the component and any arbitrary element arranged (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part may be directly electrically connected to another part or one or more intervening parts may be present therebetween such that the part and the another part are indirectly electrically connected to each other.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

FIG. 1 is a schematic block diagram illustrating an apparatus for charging or discharging a battery cell according to an embodiment of the present disclosure. FIG. 2 is a perspective view illustrating an example of a battery cell to which the apparatus for charging or discharging a battery cell of FIG. 1 may be applied. FIG. 3 is a longitudinal cross-sectional view illustrating a charging/discharging probe included in an apparatus for charging or discharging a battery cell according to an embodiment of the present disclosure, which is a view illustrating a state in which the charging/discharging probe is spaced apart from a cell terminal of a battery cell. FIG. 4 is a longitudinal cross-sectional view illustrating the charging/discharging probe included in the apparatus for charging or discharging a battery cell of FIG. 3, which is a view illustrating a state in which the charging/discharging probe is in contact with the cell terminal of the battery cell. FIG. 5 is a cross-sectional view along the line V-V of FIG. 4.

Referring to FIGS. 1 to 5, an apparatus 100 for charging or discharging a battery cell according to an embodiment of the present disclosure may be an apparatus for testing a charging or discharging performance of a battery cell in a formation process and may include a charging/discharging body 101, a battery cell support 107, and a charging/discharging probe 110.

The charging/discharging body 101 is electrically connected to a battery cell 10 through the charging/discharging probe 110 and charges or discharges the battery cell 10. During an operation of charging or discharging the battery cell 10, the charging/discharging body 101 may measure, for example, data, through which whether there is an error in a charging or discharging operation may be determined, in real time, wherein the data includes a current, a voltage, a time, or a temperature of the battery cell 10.

The battery cell support 107 supports the battery cell 10. A position of the battery cell support 107 may be fixed, or the battery cell support 107 may be movable toward the charging/discharging probe 110 and in an opposite direction such that a position thereof may be adjusted according to a specification of the battery cell 10. The charging/discharging probe 110 is electrically connected to a cell terminal 20 of the battery cell 10 that is to be subjected to a charging/discharging operation.

The battery cell 10 may be a secondary battery cell that is chargeable and dischargeable and may include a cell case 11, a pair of cell terminals 20, and an electrode assembly 18. The electrode assembly 18 may be accommodated inside the cell case 11. The electrode assembly 18 may be formed by winding or stacking a stack of a first electrode plate, a separator, and a second electrode formed in thin plate shapes or film shapes.

In an embodiment, the electrode assembly is a wound stack, and a winding axis may be parallel to a longitudinal direction of the cell case 11. In another embodiment, the electrode assembly may be a stack type, rather than a wound type; however, a shape of the electrode assembly is not limited in the present disclosure. For example, in another embodiment, the electrode assembly may be a Z-stack electrode assembly in which a positive electrode plate and a negative electrode plate are inserted into both sides of a separator bent as a Z-stack. In addition, one or more electrode assemblies may be stacked adjacent to each other and accommodated inside the cell case 11, and a number of electrode assemblies is not limited in the present disclosure. The first electrode plate of the electrode assembly may function as a negative electrode, and the second electrode plate may function as a positive electrode. However, the reverse is also possible.

The first electrode plate may be formed by applying a first electrode active material, such as graphite or carbon, on a first electrode current collector plate formed of a metal foil of copper, a copper alloy, nickel, a nickel alloy, or the like and may include a first electrode tab (or a first uncoated portion) that is an area on which the first electrode active material is not applied. The first electrode tab may function as a path for current flow between the first electrode plate and a first current collector. In some examples, when the first electrode plate is manufactured, the first electrode tab may be formed by being cut in advance to protrude to a side. The first electrode tab may protrude to a side further than the separator without separate cutting.

The second electrode plate may be formed by applying a second electrode active material, such as a transition metal oxide, on a second electrode current collector plate formed of a metal foil of aluminum or an aluminum alloy and may include a second electrode tab (or a second uncoated portion) that is an area on which the second electrode active material is not applied. The second electrode tab may function as a path for current flow between the second electrode plate and a second current collector. In some examples, when the second electrode plate is manufactured, the second electrode tab may be formed by being cut in advance to protrude to another side in advance. The second electrode tab may protrude to the other side further than the separator without separate cutting.

In some examples, the electrode assembly 18 may be accommodated in the cell case 11 together with an electrolyte. In an embodiment, in the electrode assembly, the first current collector and the second current collector may be positioned to be respectively welded and connected to the first electrode tab of the first electrode plate and the second electrode tab of the second electrode plate which are exposed at both, or opposite, sides.

Among a pair of cell terminals 20, a cell terminal 20 may be electrically connected to a current collector of the first current collector and the second current collector, and the other cell terminal 20 may be electrically connected to the other current collector of the first current collector and the second current collector. Accordingly, one cell terminal 20 of the pair of cell terminals 20 may be a positive electrode terminal, and the other cell terminal 20 may be a negative electrode terminal.

In an embodiment, the cell case 11 of the battery cell 10 may have a generally rectangular parallelepiped shape and may accommodate the electrode assembly 18 and the electrolyte therein. In an embodiment, the cell case 11 may include a metal can of which a side is open and a cap plate which closes the open side of the metal can. The pair of cell terminals 20 may be installed on the cap plate to protrude outward from the cap plate. In an embodiment, the pair of cell terminals 20 may be positioned at both, or opposite, end portions of the cap plate in a longitudinal direction.

The pair of cell terminals 20 may be disposed on a surface of the cell case 11 to be spaced apart from each other. An upper surface 12 of the cell case 11 from which the pair of cell terminals 20 protrudes may be a first surface 12 of the cell case 11. A lower surface of the cell case 11 disposed opposite to the upper surface 12 may be a second surface (not shown) of the cell case 11. The battery cell 10 may be supported on the battery cell support 107 such that the second surface of the cell case 11 faces the battery cell support 107.

A pair of side surfaces 14 that connect the upper surface 12 and the lower surface and are disposed opposite to each other may be a pair of third surfaces 14 of the cell case 11. A front surface 15 and a rear surface (not shown) of the cell case 11 parallel to each other and spaced apart from each other by the upper surface 12, the lower surface, and the pair of side surfaces 14 may be a fourth surface 15 and a fifth surface of the cell case 11.

Herein, a direction in which the first surface 12 and the second surface (not shown) of the battery cell 10 are spaced from each other will be referred to as a first direction, a direction in which the pair of third surfaces 14 are spaced from each other will be referred to as a second direction, and a direction in which the fourth surface 15 and the fifth surface are spaced from each other will be referred to as a third direction. The first direction, the second direction, and the third direction may be orthogonal to each other. For example, the first direction may be a vertical direction, the second direction may be a lateral direction, and the third direction may be a front-rear direction.

Each of the cell terminals 20 may include a first surface 21 and two pairs of second surfaces 22 and 24. The first surface 21 of the cell terminal 20 may be a surface of an end portion of the cell terminal 20 that is parallel to the first surface 12 of the cell case 11 and is spaced apart from the first surface 12 of the cell case 11. In an embodiment, a planar shape of the first surface 21 of the cell terminal 20 may have a generally rectangular shape.

Among the two pairs of second surfaces 22 and 24 of the cell terminal 20, a pair of second surfaces 22 may be first side surfaces of the cell terminal 20 that are bent and connected to the first surface 21 of the cell terminal 20 through a pair of first edges 23 of the first surface 21 of the cell terminal 20 as boundaries, and the other pair of second surfaces 24 of the cell terminal 20 may be second side surfaces that are bent and connected to the first surface 21 through a pair of second edges 25 of the first surface 21 as boundaries. In an embodiment, the first surface 21 of the cell terminal 20 may be orthogonal to the first direction, the first side surface 22 may be orthogonal to the second direction, and the second side surface 24 may be a surface orthogonal to the third direction.

The charging/discharging probe 110 included in the apparatus 100 for charging or discharging a battery cell according to an embodiment of the present disclosure may be provided as a pair of charging/discharging probes 110 to correspond to the number of cell terminals 20 of the battery cell 10. Each of the pair of charging/discharging probes 110 includes a first contact portion 111 and a second contact portion 130. The first contact portion 111 is configured to come into detachable contact with the first surface 21 of the cell terminal 20.

The second contact portion 130 may be connected to the first contact portion 111. When the first contact portion 111 comes into contact with the first surface 21 of the cell terminal 20, the second contact portion 130 may come into contact with the second surface 22 or 24 of the cell terminal 20. When the first contact portion 111 is spaced apart from the first surface 21 of the cell terminal 20, the second contact portion 130 may be spaced apart from the second surface 22 or 24 of the cell terminal 20.

In an embodiment, the second contact portion 130 may be provided as a plurality of second contact portions 130. For example, the cell terminal 20 may include two pairs of second surfaces 22 and 24, and the charging/discharging probe 110 may include four second contact portions 130, that is, two pairs of second contact portions 130.

Among the two pairs of second contact portions 130, a pair of second contact portions 130 may be disposed symmetrically with the first contact portion 111 interposed therebetween to come into contact with a pair of second surfaces 22, e.g., a pair of first side surfaces 22, and another pair of second contact portions 130 may be disposed symmetrically with the first contact portion 111 interposed therebetween to come into contact with the other pair of second surfaces 24, e.g., the pair of second side surfaces 24. However, the charging/discharging probe 110 does not necessarily include the two pairs of second contact portions 130 and may include only one pair of second contact portions 130 with the first contact portion 111 interposed therebetween.

The apparatus 100 for charging or discharging a battery cell may further include current lines 103 electrically connected to the one pair of charging/discharging probes 110 such that the battery cell 10 is charged or discharged when the one pair of charging/discharging probes 110 come into contact with one pair of cell terminals 20. When the battery cell 10 is charged or discharged, a current may flow through the current line 103.

An end portion of each of the current lines 103 may be connected to the charging/discharging body 101, and another end portion thereof may be connected to the first contact portion 111. For example, a probe connection terminal 105 may be provided at the other end portion of the current line 103, and a current line connection terminal 123 in electrical contact with the probe connection terminal 105 may be provided at an end portion of the first contact portion 111 in a longitudinal direction.

In an embodiment, a cap 125, through which the current line 103 passes and which surrounds the probe connection terminal 105, is coupled to an upper end portion of the first contact portion 111, the probe connection terminal 105 and the current line connection terminal 123 may be covered and sealed by the cap 125, and the probe connection terminal 105 and the current line connection terminal 123 may be in close contact with each other such that the first contact portion 111 and the current line 103 may be electrically connected.

The first contact portion 111 may extend in the first direction, e.g., a vertical direction. An end portion of the first contact portion 111 at which the current line connection terminal 123 is provided may be the upper end portion. Another end portion of the first contact portion 111 in the longitudinal direction may be a lower end portion, and a first surface of the lower end portion, that is, a lower surface 115, may come into electrical contact with the first surface 21 of the cell terminal 20.

The charging/discharging probe 110 may further include a support frame 153, a first contact portion pressing spring 150, and a stopper ring 127. The support frame 153 may support the first contact portion 111 and may move toward the battery cell 10 such that the first contact portion 111 comes into close contact with the first surface 21 of the cell terminal 20.

A through-hole 154 through which the first contact portion 111 passes may be formed in the support frame 153. In an embodiment, the support frame 153 may be provided to be shared by the pair of charging/discharging probes 110. Accordingly, a pair of through-holes 154 may be formed in the support frame 153 to be spaced apart from each other in the second direction such that a pair of first contact portions 111 individually pass through the pair of through-holes 154. When the support frame 153 moves in the first direction, the pair of first contact portions 111 may move together in the first direction.

The first contact portion pressing spring 150 is interposed between the support frame 153 and the first contact portion 111, and, when the first contact portion 111 comes into contact with the first surface 21 of the cell terminal 20, the first contact portion pressing spring 150 elastically presses the first contact portion 111 toward the cell terminal 20.

For example, the first contact portion pressing spring 150 may be a coil spring, and the first contact portion 111 may extend in the first direction across the first contact portion pressing spring 150. The lower end portion of the first contact portion 111 may radially expand such that a size of a radius centered on a central axis CX of the first contact portion 111 expands in a stepped manner. Here, the central axis CX may be a virtual straight line extending in the first direction to pass through a center of the first contact portion 111.

An upper end portion of the first contact portion pressing spring 150 may be supported on a lower surface of the support frame 153 around the through-hole 154, and a lower end portion of the first contact portion pressing spring 150 may be supported on a stepped surface 116 formed in a stepped manner at the lower end portion of the first contact portion 111.

The stopper ring 127 may be coupled to the upper end portion of the first contact portion 111 to be positioned above the support frame 153. The stopper ring 127 may be detachably coupled to the first contact portion 111.

In an embodiment, the first contact portion pressing spring 150 elastically presses the stepped surface 116 toward the cell terminal 20, and the stopper ring 127 may come into close contact with the support frame 153, and, unless the lower surface 115 of the first contact portion 111 does not come into contact with the first surface 21 of the cell terminal 20, when the support frame 153 moves in the first direction, the first contact portion 111 may move together with the support frame 153.

In a state in which the battery cell 10 is supported on the battery cell support 107 such that the cell terminal 20 is aligned with the central axis CX of the first contact portion 111, when the support frame 153 moves toward the battery cell 10 in the first direction, the lower surface 115 of the first contact portion 111 may come into contact with the first surface 21 of the cell terminal 20.

In this state, when the support frame 153 further moves toward the battery cell 10 in the first direction, the first contact portion pressing spring 150 may be elastically compressed to elastically press the first contact portion 111 toward the cell terminal 20 such that the lower surface 115 of the first contact portion 111 may come into close contact with the first surface 21 of the cell terminal 20.

The charging/discharging probe 110 may further include a hinge portion 140 that supports the second contact portion 130 such that the second contact portion 130 rotates with respect to the first contact portion 111. In an embodiment, a number of hinge portions 140 may be provided to correspond to the number of second contact portions 130. Each hinge portion 140 may include a hinge bracket 143 and a hinge pin 141.

One side of the hinge bracket 143 may be fixed to the lower end portion of the first contact portion 111. The hinge pin 141 may pass through the second contact portion 130 and may be supported on another side of the hinge bracket 143. For example, an end portion of the hinge bracket 143 close to the central axis CX of the first contact portion 111 may be fixed to a side surface rather than the lower surface 115 of the lower end portion of the first contact portion 111, and the hinge pin 141 may be coupled to and supported on another end portion of the hinge bracket 143.

Each second contact portion 130 may include a first end portion 131 and a second end portion 134. The first end portion 131 may protrude toward the battery cell 10 with respect to the hinge pin 141 to come into contact with a side surface of the first side surface 22 and the second side surface 24 of the cell terminal 20.

An inner surface 132 of the first end portion 131 may come into surface contact with a side surface of the first side surface 22 and the second side surface 24 of the cell terminal 20. The second end portion 134 may protrude in a direction opposite to the direction toward the battery cell 10 with respect to the hinge pin 141.

In an embodiment, when the first contact portion 111 is spaced apart from the first surface 21 of the cell terminal 20, the first end portion 131 of the second contact portion 130 may move away from the central axis CX of the first contact portion 111, and the second contact portion 130 may rotate such that the second end portion 134 of the second contact portion 130 approaches the central axis CX of the first contact portion 111.

For example, when the first contact portion 111 is lifted in the first direction to move away from the first surface 21 of the cell terminal 20, the two pairs of second contact portions 130 may rotate about the hinge pin 141 such that the first end portion 131 moves away from the central axis CX and the second end portion 134 approaches the central axis CX. In other words, the second contact portion 130 may rotate in a direction in which a plurality of first end portions 131 are spread.

When the support frame 153 is further lowered in the first direction after the lower surface 115 of the first contact portion 111 comes in contact with the first surface 21 of the cell terminal 20, the two pairs of second contact portions 130 may rotate about the hinge pin 141 such that the first end portion 131 approaches the central axis CX and the second end portion 134 moves away from the central axis CX. In other words, the second contact portion 130 may rotate in a direction in which the plurality of first end portions 131 are retracted.

The charging/discharging probe 110 may further include a rotation trigger 156. The rotation trigger 156 moves together with the support frame 153 to press the second contact portion 130 such that the second contact portion 130 rotates in a direction in which the second end portion 134 moves away from the central axis CX of the first contact portion 111, and the first end portion 131 comes into close contact with a side surface of the first side surface 22 and the second side surface 24 of the cell terminal 20.

For example, the rotation trigger 156 may protrude toward the battery cell 10 around the through-hole 154 of the support frame 153. In an embodiment, an inclined surface 157 may be formed at a lower end portion of the rotation trigger 156, and an inclined surface 135 in surface contact with the inclined surface 157 of the rotation trigger 156 may be formed at the second end portion 134 of the second contact portion 130. In an embodiment, unlike what is shown in FIGS. 3 to 5, only one of the second end portion 134 and the rotation trigger 156 may include an inclined surface in contact with the other, and the other may not include an inclined surface.

The charging/discharging probe 110 may further include a stopper 148 and a second contact portion pressing spring 145. In an embodiment, a number of each of the stoppers 148 and the second contact portion pressing springs 145 may correspond one-to-one to a number of the second contact portions 130.

Each stopper 148 limits the rotation of the second contact portion 130 such that the second end portion 134 of the second contact portion 130 is not excessively close, or proximate, to the central axis CX of the first contact portion 111.

When the rotation trigger 156 is spaced apart from the second contact portion 130, and the second contact portion 130 rotates such that the second end portion 134 is excessively close to the central axis CX of the first contact portion 111, even when the support frame 153 and the rotation trigger 156 move closer to the second contact portion 130 in the first direction, the inclined surface 157 of the rotation trigger 156 and the inclined surface 135 of the second end portion 134 do not come into contact with each other such that the first end portion 131 may not rotate in a direction in which the first end portion 131 comes into contact with the second surface 22 or 24 of the cell terminal 20. In other words, the rotation trigger 156 and the second end portion 134 may not interfere with each other.

In an embodiment, the stopper 148 may block excessive rotation of the second contact portion 130 to prevent a failure of interference between the rotation trigger 156 and the second end portion 134. The stopper 148 may be formed to protrude from the first contact portion 111 toward the second end portion 134 at a position spaced apart from the lower surface 115 by a distance that is greater than a distance from the lower surface 115 to the hinge portion 140.

The second contact portion pressing spring 145 elastically presses the second contact portion 130 such that the first end portion 131 moves away from the first contact portion 111 and the second end portion 134 approaches the first contact portion 111. The second contact portion pressing spring 145 may be disposed at a position spaced apart from the lower surface 115 by a distance that is less than the distance from the lower surface 115 to the hinge portion 140 and may be interposed between a side surface of the first contact portion 111 and an inner side surface of the first end portion 131.

The first contact portion 111, the hinge portion 140, and the second contact portion 130 may be electrically connected to each other. Accordingly, in a state in which the lower surface 115 of the first contact portion 111 is in close contact with the first surface 21 of the cell terminal 20, and the first end portion 131 of the second contact portion 130 is in contact with the second surface 22 or 24 of the cell terminal 20, a current may flow between the cell terminal 20, the second contact portion 130, the hinge portion 140, the first contact portion 111, the current line 103, and the charging/discharging body 101, and the battery cell 10 may be charged or discharged.

FIG. 6 is a longitudinal cross-sectional view illustrating a charging/discharging probe included in an apparatus for charging or discharging a battery cell according to another embodiment of the present disclosure, which is a view illustrating a state in which the charging/discharging probe is spaced apart from a cell terminal of a battery cell. FIG. 7 is a longitudinal cross-sectional view illustrating the charging/discharging probe included in the apparatus for charging or discharging a battery cell of FIG. 6, which is a view illustrating a state in which the charging/discharging probe is in contact with the cell terminal of the battery cell. FIG. 8 is a cross-sectional view along the line VIII-VIII of FIG. 7.

Referring to FIGS. 1, 2, and 6 to 8, a charging/discharging probe 210 according to the present embodiment included in an apparatus 100 for charging or discharging a battery cell of the present may be installed in the apparatus 100 for charging or discharging a battery cell of FIG. 1 instead of the charging/discharging probe 110 of the embodiment shown in FIGS. 3 to 5.

In an embodiment, the charging/discharging probe 210 may be provided as a pair of charging/discharging probes 210 to correspond to a number of cell terminals 20 of a battery cell 10. Each of the pair of charging/discharging probes 210 includes a first contact portion 211 and a second contact portion 230. The first contact portion 211 is configured to come into detachable contact with a first surface 21 of the cell terminal 20.

The second contact portion 230 may be connected to the first contact portion 211. When the first contact portion 211 comes into contact with the first surface 21 of the cell terminal 20, the second contact portion 230 may come into contact with a second surface 22 or 24 of the cell terminal 20. When the first contact portion 211 is spaced apart from the first surface 21 of the cell terminal 20, the second contact portion 230 may be spaced apart from the second surface 22 or 24 of the cell terminal 20.

The second contact portion 230 may be provided as a plurality of second contact portions 230. In an embodiment, for example, the cell terminal 20 includes a pair of first side surfaces 22 and a pair of second side surfaces 24, and the charging/discharging probe 210 may include four second contact portions 230, that is, two pairs of second contact portions 230.

In an embodiment, among the two pairs of second contact portions 230, one pair of second contact portions 230 may be disposed symmetrically with the first contact portion 211 interposed therebetween to come into contact with one pair of second surfaces 22, that is, the pair of first side surfaces 22, and the other pair of second contact portions 230 may be disposed symmetrically with the first contact portion 211 interposed therebetween to come into contact with the other pair of second surfaces 24, that is, the pair of second side surfaces 24. However, in an embodiment, the charging/discharging probe 210 does not necessarily include the two pairs of second contact portions 230 and may include only one pair of second contact portions 230 with the first contact portion 211 interposed therebetween.

The apparatus 100 for charging or discharging a battery cell may further include current lines 103 electrically connected to the pair of charging/discharging probes 210 such that the battery cell 10 is charged or discharged when the pair of charging/discharging probes 210 come into contact with the pair of cell terminals 20. When the battery cell 10 is charged or discharged, a current may flow through the current line 103.

An end portion of each of the pair of current lines 103 of the apparatus 100 for charging or discharging a battery cell may be connected to a charging/discharging body 101, and another end portion thereof may be connected to the first contact portion 211. For example, a current line connection terminal 223 in electrical contact with a probe connection terminal 105 provided at another end portion of the current line 103 may be provided at an end portion of the first contact portion 211 in a longitudinal direction.

In an embodiment, a cap 225, through which the current line 103 passes and which surrounds the probe connection terminal 105, is coupled to an upper end portion of the first contact portion 211, the probe connection terminal 105 and the current line connection terminal 223 may be covered and sealed by the cap 225, and the probe connection terminal 105 and the current line connection terminal 223 may be in close contact with each other such that the first contact portion 211 and the current line 103 may be electrically connected.

The first contact portion 211 may extend in a first direction, e.g., a vertical direction. An end portion of the first contact portion 211 at which the current line connection terminal 223 is provided may be an upper end portion. Another end portion of the first contact portion 211 in the longitudinal direction may be a lower end portion, and a first surface of the lower end portion, that is, a lower surface 115, may come into electrical contact with the first surface 21 of the cell terminal 20.

The charging/discharging probe 210 may further include a support frame 253, a first contact portion pressing spring 250, and a stopper ring 227. The support frame 253 may support the first contact portion 211 and may move toward the battery cell 10 such that the first contact portion 211 comes into close contact with the first surface 21 of the cell terminal 20.

A through-hole 254 through which the first contact portion 211 passes may be formed in the support frame 253. In an embodiment, the support frame 253 may be provided to be shared by the pair of charging/discharging probes 210. Accordingly, the pair of through-holes 254 may be formed in the support frame 153 to be spaced apart from each other in a second direction such that the pair of first contact portions 211 individually pass through one pair of through-holes 254. When the support frame 253 moves in the first direction, the pair of first contact portions 211 may move together in the first direction.

The first contact portion pressing spring 250 is interposed between the support frame 253 and the first contact portion 211, and when the first contact portion 211 comes into contact with the first surface 21 of the cell terminal 20, the first contact portion pressing spring 150 elastically presses the first contact portion 211 toward the cell terminal 20.

For example, the first contact portion pressing spring 250 may be a coil spring, and the first contact portion 211 may extend in the first direction across the first contact portion pressing spring 250. In an embodiment, the lower end portion of the first contact portion 211 may be radially expanded such that a size of a radius centered on a central axis CX of the first contact portion 211 is expanded in a stepped manner.

An upper end portion of the first contact portion pressing spring 250 may be supported on a lower surface of the support frame 253 around the through-hole 254, and a lower end portion of the first contact portion pressing spring 250 may be supported on a stepped surface 216 formed in a stepped manner at the lower end portion of the first contact portion 211.

The stopper ring 227 may be coupled to the upper end portion of the first contact portion 211 to be positioned above the support frame 253. The stopper ring 227 may be detachably coupled to the first contact portion 211.

The first contact portion pressing spring 250 elastically presses the stepped surface 216 toward the cell terminal 20, and the stopper ring 227 may come into close contact with the support frame 253, and, unless the lower surface 215 of the first contact portion 211 does not come into contact with the first surface 21 of the cell terminal 20, when the support frame 253 moves in the first direction, the first contact portion 211 may move together with the support frame 253.

In a state in which the battery cell 10 is supported on a battery cell support 107 such that the cell terminal 20 is aligned with the central axis CX of the first contact portion 211, when the support frame 253 moves toward the battery cell 10 in the first direction, the lower surface 215 of the first contact portion 211 may come into contact with the first surface 21 of the cell terminal 20.

In this state, when the support frame 253 further moves toward the battery cell 10 in the first direction, the first contact portion pressing spring 250 may be elastically compressed to elastically press the first contact portion 211 toward the cell terminal 20 such that the lower surface 215 of the first contact portion 211 may come into close contact with the first surface 21 of the cell terminal 20.

The charging/discharging probe 210 may further include a hinge portion 240 that supports the second contact portion 230 such that the second contact portion 230 rotates with respect to the first contact portion 211. In an embodiment, a number of hinge portions 240 may correspond to a number of second contact portions 230. Each hinge portion 240 may include a hinge bracket 243 and a hinge pin 241.

A side of the hinge bracket 243 may be fixed to the lower end portion of the first contact portion 211. The hinge pin 241 may pass through the second contact portion 230 and may be supported on another side of the hinge bracket 243. For example, an end portion of the hinge bracket 243 close to the central axis CX of the first contact portion 211 may be fixed to a side surface, rather than the lower surface 215 of the lower end portion of the first contact portion 211, and the hinge pin 241 may be coupled to and supported on the other end portion of the hinge bracket 243 spaced apart from an end portion of the hinge bracket 243.

Each second contact portion 230 may include a first end portion 231 and a second end portion 234. The first end portion 231 may protrude toward the battery cell 10 from the hinge pin 241 to come into contact with a side surface of the first side surface 22 and the second side surface 24 of the cell terminal 20.

An inner surface 232 of the first end portion 231 may come into surface contact with a side surface of the first side surface 22 and the second side surface 24 of the cell terminal 20. The second end portion 234 may protrude in a direction opposite to the direction toward the battery cell 10 with respect to the hinge pin 241.

In an embodiment, the second contact portion 230 may be elastically biased in a direction in which the first end portion 231 approaches the first contact portion 211 and the second end portion 234 moves away from the first contact portion 211. The charging/discharging probe 210 may further include a second contact portion pressing spring 245 that elastically presses the second contact portion 230 such that the second end portion 234 moves away from the first contact portion 211.

In an embodiment, a number of second contact portion pressing springs 245 may correspond one-to-one to a number of second contact portions 230. Accordingly, the second contact portion 230 may be elastically biased such that the first end portion 231 is closer to the central axis CX of the first contact portion 211 than the second end portion 234.

For example, the second contact portion pressing spring 245 may be a coil spring. The second contact portion pressing spring 245 may be disposed at a position spaced apart from the lower surface 215 by a distance that is greater than a distance from the lower surface 215 to the hinge portion 240 and may be interposed between a side surface of the first contact portion 211 and an inner side surface of the second end portion 234.

When the first contact portion 211 moves toward the cell terminal 20 in the first direction such that an end of the first end portion 231 comes into contact with an edge 23 or 25 between the first surface 21 of the cell terminal 20 and the second surface 22 or 24 of the cell terminal 20, that is, an edge of a first edge 23 and a second edge 25, the second contact portion 230 may rotate such that the first end portion 231 is spaced apart from the central axis CX of the first contact portion 211 and the second end portion 234 approaches the central axis CX of the first contact portion 211.

In an embodiment, when the end of the first end portion 231 comes into contact with an edge of the first edge 23 and the second edge 25, an inclined surface 233 may be formed to interfere with an edge 23 or 25 in contact therewith such that the second contact portion 230 rotates.

While the first contact portion 211 is moving toward the cell terminal 20, when the inclined surface 233 comes into contact with an edge 23 or 25 of the first edge 23 and the second edge 25, the second contact portion 230 rotates such that, while the inclined surface 233 slides against the edge 23 or 25 in contact therewith, the first end portion 231 is spaced apart from the central axis CX.

In an embodiment, a plurality of first end portions 231 are spread from each other away from the central axis CX of the first contact portion 211, and when the first contact portion 211 further moves toward the cell terminal 20 in the first direction, the lower surface 215 may come into close contact with the first surface 21 of the cell terminal 20. In this case, the inner surface 232 of the first end portion 231 may come into close contact with one side surface of the first side surface 22 and the second side surface 24 of the cell terminal 20 by an elastic restoring force of the second contact portion pressing spring 245.

The first contact portion 211, the hinge portion 240, and the second contact portion 230 may be electrically connected to each other. Accordingly, in a state in which the lower surface 215 of the first contact portion 211 is in close contact with the first surface 21 of the cell terminal 20 and the first end portion 231 of the second contact portion 230 is in contact with the second surface 22 or 24 of the cell terminal 20, a current may flow between the cell terminal 20, the second contact portion 230, the hinge portion 240, the first contact portion 211, the current line 103, and the charging/discharging body 101, and the battery cell 10 may be charged or discharged.

When the first contact portion 211 is spaced apart from the first surface 21 of the cell terminal 20 and the first end portion 231 is also spaced apart from the cell terminal 20, the second contact portion 230 may return to its original position by an elastic restoring force of the second contact portion pressing spring 245.

The charging/discharging probe 210 may further include a stopper 248. In an embodiment, a number of stoppers 248 may correspond one-to-one to a number of second contact portions 230.

Each stopper 248 limits the rotation of the second contact portion 230 such that the first end portion 231 of the second contact portion 230 is not excessively close, or proximate, to the central axis CX of the first contact portion 211.

When the first end portion 231 is excessively close to the central axis CX of the first contact portion 211 while the second contact portion 230 is spaced apart from the cell terminal 20, in a case in which the first contact portion 211 and the second contact portion 230 move together in the first direction to approach the cell terminal 20, the inclined surface 233 may not come into contact with one edge of the first edge 23 and the second edge 25 and may come into contact with the first surface 21 of the cell terminal 20 such that the second contact portion 230 may not rotate in a direction in which the first end portion 231 moves away from the central axis CX. In other words, the first end portion 231 and the edges 23 and 25 may not interfere with each other.

The stopper 248 may block excessive rotation of the second contact portion 230 to prevent or substantially prevent a failure of interference between the first end portion 231 and the edges 23 and 25. The stopper 248 may be disposed at a position spaced apart from the lower surface 215 by a distance that is less than a distance from the lower surface 215 to the hinge portion 240 and may be formed to protrude from the first contact portion 211 toward the first end portion 231.

FIG. 9 is a longitudinal cross-sectional view illustrating a charging/discharging probe included in an apparatus for charging or discharging a battery cell according to another embodiment of the present disclosure, which is a view illustrating a state in which the charging/discharging probe is spaced apart from a cell terminal of a battery cell. FIG. 10 is a longitudinal cross-sectional view illustrating the charging/discharging probe included in the apparatus for charging or discharging a battery cell of FIG. 9, which is a view illustrating a state in which the charging/discharging probe is in contact with the cell terminal of the battery cell. FIG. 11 is a cross-sectional view along the line XI-XI of FIG. 10.

Referring to FIGS. 1, 2, and 9 to 11, a charging/discharging probe 310 according to the present embodiment included in an apparatus 100 for charging or discharging a battery cell of the present may be installed in the apparatus 100 for charging or discharging a battery cell of FIG. 1 instead of the charging/discharging probe 110 of the embodiment shown in FIGS. 3 to 5.

In an embodiment, the charging/discharging probe 310 may be provided as a pair of charging/discharging probes 310 to correspond to the number of cell terminals 20 of a battery cell 10. Each of the pair of charging/discharging probes 310 includes a first contact portion 311 and a second contact portion 330. The first contact portion 311 is configured to come into detachable contact with a first surface 21 of the cell terminal 20.

The second contact portion 330 may be connected to the first contact portion 311. When the first contact portion 311 comes into contact with the first surface 21 of the cell terminal 20, the second contact portion 330 may come into contact with a second surface 22 or 24 of the cell terminal 20. When the first contact portion 311 is spaced apart from the first surface 21 of the cell terminal 20, the second contact portion 330 may be spaced apart from the second surface 22 or 24 of the cell terminal 20.

In an embodiment, the second contact portion 330 may be provided as a plurality of second contact portions 330. In an embodiment, for example, the cell terminal 20 includes two pairs of second surfaces 22 and 24, and the charging/discharging probe 310 may include four second contact portions 330, that is, two pairs of second contact portions 330.

In an embodiment, among the two pairs of second contact portions 330, a pair of second contact portions 330 may be disposed symmetrically with the first contact portion 311 interposed therebetween to come into contact with the pair of second surfaces 22, that is, the pair of first side surfaces 22, and the other pair of second contact portions 330 may be disposed symmetrically with the first contact portion 311 interposed therebetween to come into contact with the other pair of second surfaces 24, that is, the pair of second side surfaces 24. However, the charging/discharging probe 310 does not necessarily include two pairs of second contact portions 330 and may include only one pair of second contact portions 330 with the first contact portion 311 interposed therebetween.

The apparatus 100 for charging or discharging a battery cell may further include current lines 103 electrically connected to the pair of charging/discharging probes 310 such that a battery cell 10 is charged or discharged when the one pair of charging/discharging probes 310 come into contact with the pair of cell terminals 20. When the battery cell 10 is charged or discharged, a current may flow through the current line 103.

An end portion of each of one pair of current lines 103 of the apparatus 100 for charging or discharging a battery cell may be connected to a charging/discharging body 101, and another end portion thereof may be connected to the first contact portion 311. For example, a current line connection terminal 323 in electrical contact with a probe connection terminal 105 provided at the other end portion of the current line 103 may be provided at an end portion of the first contact portion 311 in a longitudinal direction.

In an embodiment, a cap 325, through which the current line 103 passes and which surrounds the probe connection terminal 105, is coupled to an upper end portion of the first contact portion 311, the probe connection terminal 105 and the current line connection terminal 323 may be covered and sealed by the cap 325, and the probe connection terminal 105 and the current line connection terminal 323 may be in close contact with each other such that the first contact portion 311 and the current line 103 may be electrically connected.

The first contact portion 311 may extend in a first direction, e.g., a vertical direction. An end portion of the first contact portion 311 at which the current line connection terminal 323 is provided may be an upper end portion. Another end portion of the first contact portion 311 in the longitudinal direction may be a lower end portion, and a first surface of the lower end portion, that is, a lower surface 315, may come into electrical contact with the first surface 21 of the cell terminal 20.

The charging/discharging probe 310 may further include a support frame 353, a first contact portion pressing spring 350, and a stopper ring 327. The support frame 353 may support the first contact portion 311 and may move toward the battery cell 10 such that the first contact portion 311 comes into close contact with the first surface 21 of the cell terminal 20.

A through-hole 354 through which the first contact portion 311 passes may be formed in the support frame 353. In an embodiment, the support frame 353 may be provided to be shared by the pair of charging/discharging probes 310. Accordingly, a pair of through-holes 354 may be formed in the support frame 353 to be spaced apart from each other in a second direction such that the pair of first contact portions 311 individually pass through the pair of through-holes 354. When the support frame 353 moves in the first direction, the pair of first contact portions 311 may move together in the first direction.

The first contact portion pressing spring 350 is interposed between the support frame 353 and the first contact portion 311, and when the first contact portion 311 comes into contact with the first surface 21 of the cell terminal 20, the first contact portion pressing spring 350 elastically presses the first contact portion 311 toward the cell terminal 20.

For example, the first contact portion pressing spring 350 may be a coil spring, and the first contact portion 311 may extend in the first direction across the first contact portion pressing spring 350. The lower end portion of the first contact portion 311 may be radially expanded such that a size of a radius centered on a central axis CX of the first contact portion 311 is expanded in a stepped manner.

An upper end portion of the first contact portion pressing spring 350 may be supported on a lower surface of the support frame 353 around a through-hole 354, and a lower end portion of the first contact portion pressing spring 350 may be supported on a stepped surface 316 formed in a stepped manner at a lower end portion of the first contact portion 311.

The stopper ring 327 may be coupled to the upper end portion of the first contact portion 311 to be positioned above the support frame 353. In an embodiment, the stopper ring 327 may be detachably coupled to the first contact portion 311.

In an embodiment, the first contact portion pressing spring 350 elastically presses the stepped surface 316 toward the cell terminal 20, and the stopper ring 327 may come into close contact with the support frame 353, and, unless the lower surface 315 of the first contact portion 311 does not come into contact with the first surface 21 of the cell terminal 20, when the support frame 353 moves in the first direction, the first contact portion 311 may move together with the support frame 353.

In a state in which the battery cell 10 is supported on a battery cell support 107 such that the cell terminal 20 is aligned with the central axis CX of the first contact portion 311, when the support frame 353 moves toward the battery cell 10 in the first direction, the lower surface 315 of the first contact portion 311 may come into contact with the first surface 21 of the cell terminal 20.

In this state, when the support frame 353 further moves toward the battery cell 10 in the first direction, the first contact portion pressing spring 350 may be elastically compressed to elastically press the first contact portion 311 toward the cell terminal 20 such that the lower surface 315 of the first contact portion 311 may come into close contact with the first surface 21 of the cell terminal 20.

In an embodiment, the second contact portion 330 may include a leaf spring 331 and a leaf spring fastener 340. In an embodiment, the leaf spring 331 may include a terminal contact portion 333, a contact piece fixing portion 336, and a guide portion 338 which are integrally formed.

The contact piece fixing portion 336 may be fixed to the first contact portion 311. The contact piece fixing portion 336 is fixed to the first contact portion 311. The leaf spring fastener 340 may fix the contact piece fixing portion 336 to the first contact portion 311 and may be, for example, a fastening bolt. The contact piece fixing portion 336 may be fixed to a side surface of the lower end portion of the first contact portion 311. In an embodiment, however, unlike that shown in FIGS. 9 to 11, the contact piece fixing portion 336 and the first contact portion 311 may be joined through a method, such as a welding method, without the use of a leaf spring fastener.

The terminal contact portion 333 may extend from the contact piece fixing portion 336 to come into contact with the second surface 22 or 24 of the cell terminal 20. An inner surface 334 of the terminal contact portion 333 may come into surface contact with a side surface of the first side surface 22 and the second side surface 24 of the cell terminal 20.

When the terminal contact portion 333 comes into contact with the second surface 22 or 24 of the cell terminal 20, the terminal contact portion 333 may come into elastic contact with the second surface 22 or 24 of the cell terminal 20.

When the first contact portion 311 moves toward the cell terminal 20 in the first direction while spaced apart from the cell terminal 20, the guide portion 338 comes into contact with the cell terminal 20 prior to the terminal contact portion 333. The guide portion 338 may extend from the terminal contact portion 333 to be bent with respect to the terminal contact portion 333.

An end portion of the terminal contact portion 333 in the first direction may be connected to the contact piece fixing portion 336, and another end portion of the terminal contact portion 333 may be connected to the guide portion 338. In a state in which the first contact portion 311 and the second contact portion 330 are spaced apart from the cell terminal 20, the other end portion of the terminal contact portion 333 and the guide portion 338 may protrude closer to the cell terminal 20 than the lower surface 315 of the first contact portion 311.

The leaf spring 331 may be elastically biased such that the other end portion of the terminal contact portion 333 is closer to the central axis CX of the first contact portion 311 than the contact piece fixing portion 336.

While the first contact portion 311 is moved toward the cell terminal 20 in the first direction, when the guide portion 338 of the second contact portion 330 comes into contact with an edge 23 or 25 of a first edge 23 and a second edge 25, the leaf spring 331 is elastically deformed such that, while the guide portion 338 slides against an edge 23 or 25 in contact therewith, the terminal contact portion 333 is spaced apart from the central axis CX.

In an embodiment, the terminal contact portions 333 of a plurality of first end portions 231 are spread from each other away from the central axis CX of the first contact portion 311, and when the first contact portion 311 further moves toward the cell terminal 20 in the first direction, the lower surface 315 may come into close contact with the first surface 21 of the cell terminal 20. In this case, the inner surface 334 of the terminal contact portion 333 may come into close contact with a side surface of the first side surface 22 and the second side surface 24 of the cell terminal 20 by an elastic restoring force of the leaf spring 331.

The first contact portion 311 and the second contact portion 330 may be electrically connected to each other. Accordingly, in a state in which the lower surface 315 of the first contact portion 311 is in close contact with the first surface 21 of the cell terminal 20, and the terminal contact portion 333 of the leaf spring 331 of the second contact portion 330 is in contact with the second surface 22 or 24 of the cell terminal 20, a current may flow between the cell terminal 20, the second contact portion 330, the first contact portion 311, the current line 103, and a charging/discharging body 101, and the battery cell 10 may be charged or discharged.

When the first contact portion 311 is spaced apart from the first surface 21 of the cell terminal 20 and the terminal contact portion 333 is also spaced apart from the cell terminal 20, the leaf spring 331 may return to its original shape by an elastic restoring force.

The charging/discharging probes 110, 210, and 310 of the embodiments described with reference to FIGS. 1 to 11 may be probes in which one pair of cell terminals 20 protruding from an upper surface 12 of a cell case 11 charge or discharge a battery cell 10, but the present disclosure is not limited thereto. For example, the charging/discharging probe of the present disclosure can be applied to the charge/discharge of a battery cell including a pair of cell terminals individually protruding from a pair of side surfaces 14 of the cell case 11.

According to embodiments of the present disclosure, a charging/discharging probe comes into contact with not only a first surface of a cell terminal but also a second surface of the cell terminal, and a battery cell can therefore be charged or discharged at high speed.

Further, according to embodiments of the present disclosure, heat generation may be minimized or reduced at a portion at which a cell terminal and a charging/discharging probe come into contact with each other, and performance degradation, damage, or fire accidents in a battery cell or an apparatus for charging or discharging a battery cell can therefore be prevented or substantially prevented.

Although the present disclosure has been described with regard to a limited number of embodiments and drawings, the present disclosure is not limited thereto and it will be obvious to those skilled in the art that various modifications and changes may be made thereto within the scope of the present disclosure and the appended claims.

## Claims

1. An apparatus (100) for charging or discharging a battery cell (10), the apparatus comprising:
a charging/discharging probe (110, 210, 310) comprising a first contact portion (111, 211, 311) configured to come into detachable contact with a first surface (21) of a cell terminal (20) protruding from a battery cell (10), and a second contact portion (130, 230, 330) which is connected to the first contact portion (111), configured to come into contact with a second surface (22, 24) of the cell terminal (20) when the first contact portion (111) comes into contact with the first surface (21) of the cell terminal (20) and to be spaced apart from the second surface (22, 24) of the cell terminal (20) when the first contact portion (111) is spaced apart from the first surface (21) of the cell terminal (20); and
a charging/discharging body (101) electrically connectable to the battery cell (10) through the charging/discharging probe (110) such that the battery cell (10) is charged or discharged.

2. The apparatus according to claim 1, wherein the charging/discharging probe (110) further comprises a hinge portion (140, 240, 340) configured to support the second contact portion (130) such that the second contact portion (130) is configured to rotate with respect to the first contact portion (111).

3. The apparatus according to claim 2, wherein the first contact portion (111), the hinge portion (140), and the second contact portion (130) are electrically connected to each other.

4. The apparatus according to claim 2 or 3, wherein the hinge portion (140, 240) comprises a hinge bracket (143, 243) of which a first side is fixed to the first contact portion (111, 211), and a hinge pin (141, 241) which passes through the second contact portion (130, 230) and is supported on a second side of the hinge bracket (143, 243).

5. The apparatus according to claim 4, wherein the second contact portion (130) comprises:
a first end portion (131) protruding in a first direction toward the battery cell (10) from the hinge pin (141) and configured to come into contact with the second surface (22, 24) of the cell terminal (20), and a second end portion (134) protruding in a second direction opposite to the first direction from the hinge pin (141), and
the second contact portion (130) is rotatable such that, when the first contact portion (111) is spaced from the first surface (21) of the cell terminal (20), the first end portion (131) is configured to move away from a central axis of the first contact portion (111), and the second end portion (134) is configured to approach the central axis of the first contact portion (111).

6. The apparatus according to claim 5, wherein the charging/discharging probe (110) further comprises:
a support frame (153) which supports the first contact portion (111) and is movable to approach the battery cell (10) when the first contact portion comes into contact with the first surface (21) of the cell terminal (20); and
a rotation trigger (156) which is configured to move together with the support frame (153) to press the second contact portion (130) such that the second contact portion rotates in a direction in which the second end portion (134) moves away from the central axis of the first contact portion (111) and the first end portion (131) comes into close contact with the second surface (22, 24) of the cell terminal (20).

7. The apparatus according to claim 6, wherein at least one of the rotation trigger (153) and the second end portion (134) comprises an inclined surface in contact with the other one of the rotation trigger (153) and the second end portion (134).

8. The apparatus according to one of claims 5 to 7, wherein the charging/discharging probe (110) further comprises a stopper (148) configured to limit rotation of the second contact portion (130) such that the second end portion (134) is spaced away from the first contact portion (111).

9. The apparatus according to one of claims 5 to 8, wherein the charging/discharging probe further comprises a second contact portion pressing spring (145) between the first end portion (131) and the first contact portion (111) and configured to elastically press the second contact portion (130) such that the first end portion (131) moves away from the first contact portion (111) and the second end portion (134) approaches the first contact portion (111).

10. The apparatus according to claim 4, wherein the second contact portion (230) comprises:
a first end portion (231) protruding in a first direction toward the battery cell (10) from the hinge pin (241) to come into contact with the second surface (22, 24) of the cell terminal (20), and a second end portion (234) protruding from the hinge pin (241) in a second direction opposite to the first direction; and
the second contact portion (230) is elastically biased in a direction in which the first end portion (231) approaches the first contact portion (211) and the second end portion (234) moves away from the first contact portion (211).

11. The apparatus according to claim 10, wherein, when the first contact portion (211) moves toward the cell terminal (20) and an end of the first end portion (231) comes into contact with an edge (23) between the first surface (21) of the cell terminal (20) and the second surface (22, 24) of the cell terminal (20), the second contact portion (230) is configured to rotate so that the first end portion (231) moves away from a central axis (CX) of the first contact portion (211) and the second end portion (234) approaches the central axis of the first contact portion.

12. The apparatus according to claim 10 or 11, wherein the charging/discharging probe (110) further comprises:
a stopper (243) configured to limit rotation of the second contact portion (230) such that the first end portion (231) is spaced from a central axis (CX) of the first contact portion (211); and/or
a second contact portion pressing spring (245) between the second end portion (234) and the first contact portion (211) and configured to elastically press the second contact portion (230) such that the second end portion (234) moves away from the first contact portion (211).

13. The apparatus according to claim 1, wherein the second contact portion comprises a leaf spring (331) comprising a contact piece fixing portion (336) fixed to the first contact portion (311), and a terminal contact portion (333) extending from the contact piece fixing portion (336) to come into contact with the second surface (22, 24) of the cell terminal (20), and
when the terminal contact portion (333) comes into contact with the second surface of the cell terminal, the terminal contact portion is configured to come into elastic contact with the second surface (22, 24) of the cell terminal (20).

14. The apparatus according to claim 13, wherein the leaf spring (331) further comprises a guide portion (338) which, when the first contact portion (311) moves toward the cell terminal (20), is adapted to come into contact with the cell terminal (20) prior to the terminal contact portion (333) and to extend from the terminal contact portion (333) to be bent with respect to the terminal contact portion (333).

15. The apparatus according to claim 14, wherein, when the guide portion (338) comes into contact with an edge (23) between the first surface (21) of the cell terminal and the second surface (22, 24) of the cell terminal (20), the guide portion (338) is configured to slide against the edge (23), and the terminal contact portion (333) is configured to come into contact with the second surface (22, 24) of the cell terminal (20).
